(19) Europäisches Patentamt
European Patent Office
Office européen des brevets

(11) **EP 1 480 228 B1**

(12) **EUROPEAN PATENT SPECIFICATION**

(45) Date of publication and mention
of the grant of the patent:
**16.02.2011 Bulletin 2011/07**

(51) Int Cl.:
**G11C 29/00** (2006.01)

(21) Application number: **03291208.1**

(22) Date of filing: **22.05.2003**

(54) **Method and device for at-speed storage of faults for built-in self-repair (BISR) of embedded-RAMs**

Verfahren und Schaltung zur verzögerungsfreien Speicherung von Fehlern zur Selbstreparatur von eingebetteten RAM-Speichern

Procédé et circuit pour stocker sans délai des erreurs pour l'autoréparation des mémoires RAM emboîtées

(84) Designated Contracting States:
**DE FR GB IT**

(43) Date of publication of application:
**24.11.2004 Bulletin 2004/48**

(73) Proprietor: **Infineon Technologies AG**
**85579 Neubiberg (DE)**

(72) Inventor: **Borri, Simone**
**06600 Antibes (FR)**

(74) Representative: **Lange, Thomas et al**
**Patentanwälte**
**Lambsdorff & Lange**
**Dingolfinger Strasse 6**
**81673 München (DE)**

(56) References cited:
**US-A- 5 987 632    US-B1- 6 343 366**

• **NAGURA, Y.: "Test cost reduction by at-speed BISR for embedded DRAMs" ITC INTERNATIONAL TEST CONFERENCE, 2001, page 182-187 XP001165745 Charlotte**
• **SCHÖBER, V.: "Memory Built-In Self-Repair using redundant words" ITC INTERNATIONAL TEST CONFERENCE, 2001, pages 995-1001, XP002255147 Charlotte**
• **SIMONE BORRI ET AL: "A recursive at-speed Built-In Self-Repair (BISR) method for the allocation of redundant rows and columns in an embedded-RAM" 20021201, vol. 2002-12, 1 December 2002 (2002-12-01) , page 37, XP007006014**

**Description**

The present invention relates to a method for at-speed storage of faults for Built-In Self-Repair (BISR) of embedded-RAMs according to the pre-characterizing portion of claim 1. Furthermore the invention relates to a fault storage table circuit device for at-speed storage of faults for Built-In Self-Repair (BISR) of embedded-RAMs according to the pre-characterizing portion of claim 6.

A generic method for at-speed storage of faults for Built-In Self-Repair (BISR) of embedded-RAMs according to the pre-characterizing portion of claim 1 as well as a generic fault storage table circuit device for at-speed storage of faults for Built-In Self-Repair (BISR) of embedded-RAMs according to the pre-characterizing portion of claim 6 are known from Borri, S.: "A recursive 'at-speed' Built-In Self-Repair (BISR) method for the allocation of redundant rows and columns in an embedded-RAM", Siemens Technology Report, Dec. 2002, pp. 37 to 41.

Large embedded-RAMs usually employ wordline and/or bitline redundancy for yield improvement. When both spare rows and columns are present, the allocation of the redundant resources can be efficiently determined only when the full memory failure bitmap is known in advance. Since the complete bitmap can not be stored on-chip, there is a need for a mechanism to reduce the amount of information necessary to perform the diagnosis, while keeping full repair efficiency. The repair efficiency is defined as the following quotient: number of repaired memories / number of repairable memories.

During "at-speed" memory test, an additional constraint is that the test algorithm can not be stopped; otherwise the delay fault coverage would be affected. Therefore the storage of the faulty bitmaps has to be performed on-line during the BIST (Built-In Self-Test) algorithm and must complete within one clock cycle. For word-based memories (like the embedded-SRAMs, i.e. Static Random Access Memories, commonly used at Infineon) this implies the need to handle several bit faults in the same logical word, which can be detected in the same read cycle. So multiple-bit faults can appear at each cycle, and all of them must be handled within one clock cycle.

Most Built-In Self-Analysis / Repair (BISA / BISR) solutions available today focus on compressing the faulty bitmaps to reduce the area of the storage table. Being this compression performed during BIST, these methods need significant on-line processing capability during the test, so that they can not complete within only one clock cycle (i.e. they are not suitable for at-speed BIST) or their implementation leads to a large logic area overhead.

The architecture described in Bhavsar, D. K.: "An Algorithm for Row-Column Self-Repair of RAMs and Its Implementation in the Alpha 21264", Proc. of the International Test Conference (ITC) 1999, pp. 311 to 318 is possibly implemented with no cycle penalty but it is intended only for a one-row one-column redundancy with no extension possible.

In Kim, H.-C. et al.: "A BISR (Built-In Self-Repair) circuit for embedded memory with multiple redundancies", Proc. of IEEE 6th International Conference on VLSI and CAD (ICVC), 1999, pp. 602 to 605 the BIST has to be stopped for several cycles to allow the BISR engine to perform the needed on-line calculations. This pre-processing is necessary to analyze the failure bitmap and update the so-called Row / Column Fill Entries.

The architecture presented in Kawagoe, T. et al.: "A Built-In Self-Repair Analyzer (CRESTA) for embedded DRAMs", Proc. of the International Test Conference (ITC) 2000, pp. 567 to 574 is quite general but it makes use of dedicated CAMs whose area overhead increases exponentially with the number of spare rows and columns. Moreover single-cycle operation is achieved for bit-oriented memories only and it is not directly extendable to word-based memories without losing clock cycles.

The redundancy analyzer described in Nakahara, S. et al.: "Built-In Self-Test for GHz Embedded SRAMs Using Flexible Pattern Generator and new Repair Algorithm", Proc. of the International Test Conference (ITC) 1999, pp. 301 to 310 handles word-based memories with a single-cycle architecture, but at the expense of a reduced repair efficiency. This is caused by the use of a lossy compression scheme in which the information about bit error locations gets lost in case that multiple bit errors are detected in the same memory word.

The Repair Analysis (RA) unit described in Nagura, Y.: "Test cost reduction by at-speed BISR for embedded DRAMs", Proc. of the International Test Conference (ITC) 2001, pp. 182 to 187 solves all the previous issues reaching high repair efficiency. However parallel processing of the I/O data lines and pipelined structures cause a significant area increase (20 Kgates + 9 small SRAMs => 1.7 sqmm in 0.18 $\mu$m technology for the complete BISR). Thus this solution can be efficiently employed only for very large embedded-RAMs.

The main issue of the above described solutions is the need for on-line processing during BIST. Eventually the advantage coming from the size reduction of the fault storage table is weighed down by the increase of the preprocessing logic needed for bitmap compression. The situation gets worse for word-oriented memories in which several bit failures can be detected in the same clock-cycle, so that extensive parallel processing is needed to ensure single-cycle operation of the pre-processing logic.

It is an object of the present invention to provide a method and a fault storage table circuit device for at-speed storage of faults for Built-In Self-Repair (BISR) of embedded-RAMs, which method and device require reduced on-line computational overhead and provide a better speed performance in comparison with the state of the art.

According to the invention this object is achieved by a method according to claim 1 and by a device according to claim 4.

According to the present invention it is proposed to store the full failure bitmap for each failing word in a fault storage table. No bitmap compression is performed, significantly reducing the on-line computational overhead in comparison with most of the methods and devices from the state of the art. Moreover, the storage of the faults in the same cycle in which they are detected, is a feature which ensures a better speed performance of the method and device according to the invention even in comparison with the above mentioned generic method and device using full failure bitmap storage for each failing word, too.

The main advantages of the solution according to the invention are as follows:

- Reduced online processing during test. No bitmap compression necessary. The redundancy analysis is delayed to the end of test, so that it can be efficiently performed by low-speed logic (possibly by an on-chip microprocessor) with no need for dedicated parallel structures.

- One-cycle architecture. Suitable for at-speed BIST of word-based memories.

- Independent of the BIST algorithm.

- Can be used for ANY configuration of redundant resources.

- Small area overhead when compared to solutions with the same characteristics (e.g. compared with the solution described in Nagura, Y.: "Test cost reduction by at-speed BISR for embedded DRAMs", Proc. of the International Test Conference (ITC) 2001, pp. 182 to 187).

- The dimension N of the fault storage table can be traded off for the repair efficiency.

Preferred and advantageous embodiments of the method according to the invention are subject matter of claims 2 to 5. Preferred and advantageous embodiments of the device according to the invention are subject matter of claims 6 to 13.

Examples of preferred and advantageous embodiments of the invention will now be described with respect to the accompanying drawings in which

Fig. 1   is a top level block diagram of an embodiment of a fault storage table circuit device according to the invention,
Fig. 2   is a scheme of a circuit architecture of the i-th line in the fault storage table of the device of Fig. 1, and
Fig. 3   is a scheme of a circuit architecture of the common control logic block of the device of Fig. 1.

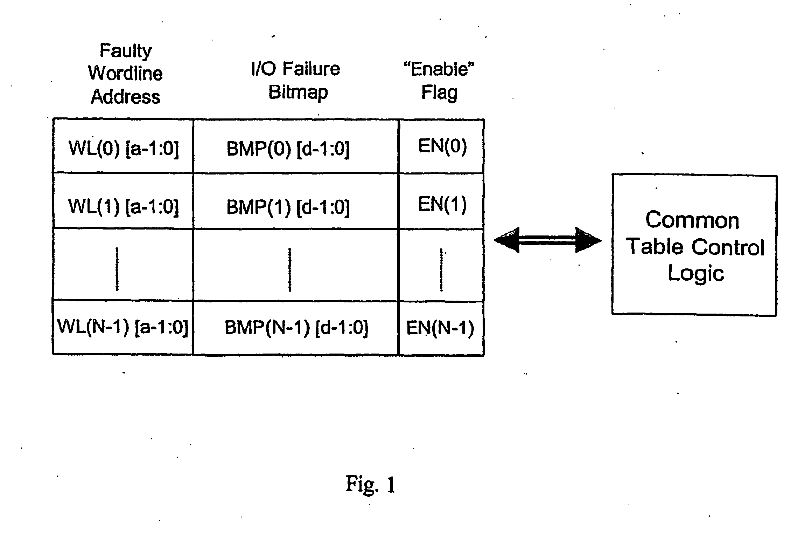

An embodiment of a fault storage table circuit device according to the invention, as it will be described in more detail hereinbelow, comprises a fault storage table and a common table control logic block (cf. Fig. 1). The fault storage table stores the wordline address, the faulty bitmap and a flag indicating that the location has already been used. The number (N) of lines of the fault storage table is determined in such a way that, if all the lines have been used, there is at least one forced choice for a spare wordline or a spare bitline. Therefore the redundancy allocation can start with no impact on the repair efficiency, for instance - but not necessarily - applying the recursive algorithm described in Borri, S.: "A recursive 'at-speed' Built-In Self-Repair (BISR) method for the allocation of redundant rows and columns in an embedded-RAM", Siemens Technology Report, Dec. 2002, pp. 37 to 41.

Otherwise, if not all the lines are used, then all the memory faults have been stored and a full redundancy allocation algorithm, e.g. the exhaustive search procedure described in Kawagoe, T. et al.: "A Built-In Self-Repair Analyzer (CRESTA) for embedded DRAMs", Proc. of the International Test Conference (ITC) 2000, pp. 567 to 574, can now be run off-line.

Given a memory array with m spare wordlines and p spare I/Os, it can be shown (see below at the end of the current specification) that the minimum value of N which is necessary to have at least one forced choice is:

$$N_{min} = m \cdot (p+1) + 1 = m \cdot p + m + 1$$

If this condition is met, it is ensured that a proper redundancy allocation algorithm (see e.g. Borri, S.: "A recursive 'at-speed' Built-In Self-Repair (BISR) method for the allocation of redundant rows and columns in an embedded-RAM", Siemens Technology Report, Dec. 2002, pp. 37 to 41.) can lead to the optimal repair solution (maximum repair efficiency). However the size of the fault storage table N can be reduced if one accepts a slight degradation of the repair efficiency.

In this case the final repair rate will depend on the N value and on the particular redundancy allocation algorithm chosen.

The architecture of an embodiment of a proposed fault storage table according to the invention is shown in Fig. 1.

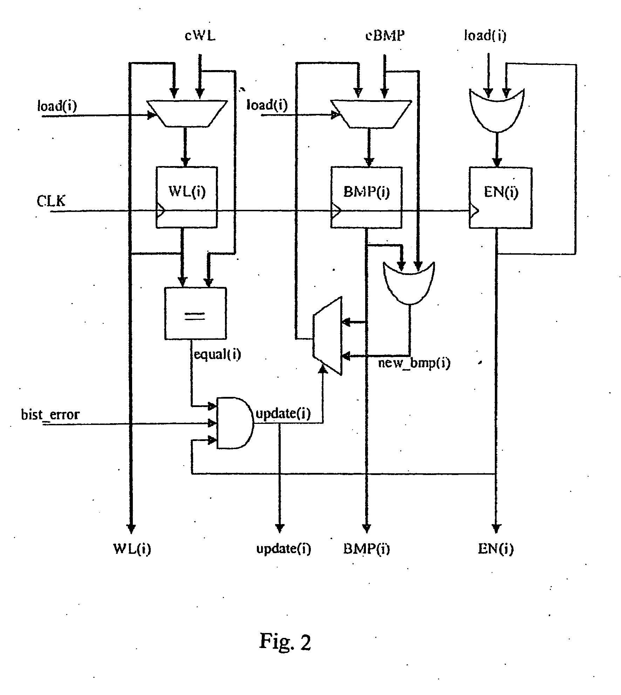

The fault storage table is composed of N lines, each one including a wordline address register WL(i), a faulty bitmap register BMP(i) and an enable flag register EN(i). The detailed diagram of the i-th line is shown in Fig. 2.

When an error is detected (bist_error becomes set for one cycle), if the current faulty wordline address (cWL) is equal to the already stored WL(i) and the corresponding enable flag is set, then an update signal update(i) is activated for the i-th line of the table. Then the failure bitmap of the i-th line is updated by a bit-by-bit OR between the current bitmap value cBMP and the old one BMP(i).

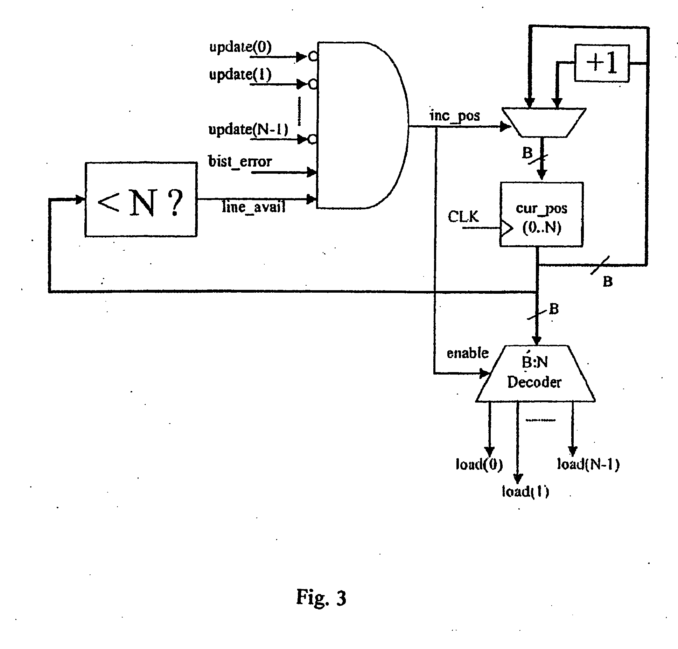

The architecture of the control logic block is depicted in Fig. 3. A common counter cur_pos is used to point to the first available (blank) line of the fault storage table. The value of the common counter cur_pos can vary between 0 and N, wherein N, as above, is the number of lines in the fault storage table, so its output has B bits, where B=ceiling $(\log_2(N+1))$. In case that the wordline address is not already stored in the fault storage table, i.e. all the update(i) signals are zero, the common logic block activates a load signal load(i) (with i=cur_pos) which commands the cur_pos-th line to store the current wordline address and faulty bitmap coming from the BIST, also setting the corresponding EN(i) flag. At the same time an incrementing signal inc_pos is activated, which increments the common counter cur_pos in the following cycle. The load(i) and inc_pos signals are activated only if the cur_pos value is less than N.

Therefore, once that the fault storage table is full (cur_pos=N) no more wordline addresses may be stored, and only the bitmap of the already stored wordlines can be updated. This is necessary because other bit faults belonging to the same wordline can be detected in subsequent phases of the test algorithm.

In view of the advantages of the present invention as outlined above, nevertheless it should be noted that at some embodiments of the present invention the area overhead may become important with large amount of redundancy because the table size N has to be proportional to m·p(m=number of spare wordlines, p=number of spare I/Os) to have the maximum repair efficiency. The table size also depends on the memory word width. Thus the area efficiency is better for memories with I/O based redundancy (as is the case for Infineon embedded SRAMs) and small I/O count. Furthermore it may happen that not all the faults get stored in the fault storage table during the first test pass. This implies the need to re-run the BIST several times for memories with complex failure bitmaps (see Borri, S.: "A recursive 'at-speed' Built-In Self-Repair (BISR) method for the allocation of redundant rows and columns in an embedded-RAM", Siemens Technology Report, Dec. 2002, pp. 37 to 41.).

VHDL (Very High-Speed Integrated Circuit Hardware Description Language) RTL (Register Level Transfer) descriptions, simulations and synthesis have been performed for the same case as it was simulated in Borri, S.: "A recursive 'at-speed' Built-In Self-Repair (BISR) method for the allocation of redundant rows and columns in an embedded-RAM", Siemens Technology Report, Dec. 2002, pp. 37 to 41 (i.e.: number of logical words = 8192, data width = 32, number of bitlines = 512, and number of wordlines = 512). The total area overhead is quite small: synthesis results in 0.18 $\mu$m technology for the case of the example (one memory of 8Kx32 with 1 redundant WL + 2 redundant I/Os, one for each side of the memory array, and fault storage table with N=3 locations) give a total area overhead (BIST + redundancy allocation + fault storage table + redundancy activation registers) of ~ 0.06 mm$^2$ (~5.5 Kgates). This figure is considerably smaller than the 1.7 mm$^2$ reported in Nagura, Y.: "Test cost reduction by at-speed BISR for embedded DRAMs", Proc. of the International Test Conference (ITC) 2001, pp. 182 to 187, although part of this difference is due to significant specifications discrepancies.

Summarizing it is stated that the present invention provides a mechanism to store detected memory faults, which mechanism minimizes on-line processing during the execution of the BIST algorithm and is thus suitable for at-speed BIST/BISR. No bitmap compression is performed and the full failure bitmap of a certain wordline is stored (and/or updated). This can easily be accomplished within one clock cycle without stopping the BIST algorithm. For word-oriented memories, in which multiple bit faults may be detected in the same memory access, direct bitmap storage avoids the need for massive parallel pre-processing and has no impact on the repair efficiency. This architecture is extensible to any configuration of spare wordlines/IOs, with the only drawback of requiring an increasing number of locations. However the fault table size can be traded off for the overall repair efficiency. A significant area advantage is demonstrated over equivalent solutions as they were described e.g. in Nagura, Y.: "Test cost reduction by at-speed BISR for embedded DRAMs", Proc. of the International Test Conference (ITC) 2001, pp. 182 to 187.

Last but not least as already announced above it should now be given an explication of the formula for $N_{min}$.

Given a memory array with r spare rows and s spare columns, it was shown in Bhavsar, D. K.: "An Algorithm for Row-Column Self-Repair of RAMs and Its Implementation in the Alpha 21264", Proc. of the International Test Conference (ITC) 1999, pp. 311 to 318 that the condensed maximally repairable sparse failure array (MSFA) has r*(s+1) rows and s*(r+1) columns. See Bhavsar, D. K.: "An Algorithm for Row-Column Self-Repair of RAMs and Its Implementation in the Alpha 21264", Proc. of the International Test Conference (ITC) 1999, pp. 311 to 318, and in particular Fig. 1 on page 313 there, for details of the MSFA definition.

According to an embodiment of the current invention the fault storage table stores partially condensed MSFA. The condensed values are in the vertical direction only (row addresses), and in the horizontal direction the full failure bitmaps are stored (there is no column "condensation").

Therefore, allowing for the storage of one more row than the condensed MSFA will lead to one of the following situations at the end of the test:

1. If there is one row (column) with more faults than the number of available spare columns (rows), then at least one "row-must"/"column-must" forced choice exists. This forces the allocation of at least one spare row/column, and the test can now be run again.
2. There is no forced repair and the table is full (i.e. all the lines have been used). Since the table contains more rows than the MSFA, then the memory is not repairable.
3. There is no forced repair and the table is not full. In this case it is ensured that all the faults are stored in the table, so that the MSFA can now be analyzed by a proper allocation algorithm.

Hence, the minimum value of N needed to perform at least one sensible row/column choice is:

$$N_{min} = \text{Number\_of\_rows\_of\_MSFA} + 1 = r \cdot (s+1) + 1 = r \cdot s + r + 1$$

If this condition is met, then there is no impact on the final repair efficiency, provided that a proper allocation algorithm is used. Such "proper" allocation algorithms are already known to persons skilled in the art. Several algorithms have been presented in the literature. One of these is the exhaustive procedure described in Kawagoe, T. et al.: "A Built-In Self-Repair Analyzer (CRESTA) for embedded DRAMs", Proc. of the International Test Conference (ITC) 2000, pp. 567 to 574.

It has to be noted that the formula given above is indeed applicable to the general case of r rows and s columns. However, it is not directly applicable to the case described in Borri, S.: "A recursive 'at-speed' Built-In Self-Repair (BISR) method for the allocation of redundant rows and columns in an embedded-RAM", Siemens Technology Report, Dec. 2002, pp. 37 to 41 since in that case the spare I/Os have some additional constraints in terms of allocation (each I/O can only be used for each half of the memory). In this case a minimum value for N still exists but it is fairly more complex to calculate.

## Claims

1. Method for storage of faults for Built-In Self-Repair (BISR) of embedded-RAMs, wherein a fault storage table composed of N lines is used (N is an integer), each one including a wordline address register (WL(i)) and wherein the faults are stored in the same cycle in which they are detected,
   **characterized in that** when an error is detected if a current faulty wordline address (cWL) is equal to the wordline address already stored in the wordline address register (WL(i)) and a corresponding enable flag is set, then an update signal (update(i)) is activated for the i-th line of the fault storage table, and then a full failure bitmap of the failing i-th line is stored by updating by a bit-by-bit OR-operation between a current failure bitmap value (cBMP) and an old one stored in a faulty bitmap register (BMP(i)).

2. Method according to claim 1,
   **characterized in that** the number N of lines of the fault storage table is determined in such a way that, if all the lines have been used, there is at least one forced choice for a spare wordline or a spare bitline or the memory array with the BISR declared unrepairable with the given number of spare wordlines or bitlines.

3. Method according to any of the preceding claims,
   **characterized in that** the number N of lines of the fault storage table is equal to or greater than a number $N_{min}$, wherein said number $N_{min}$ is calculated as $N_{min} = m \cdot (p+1) + 1 = m \cdot p + m + 1$ with m being the number of spare wordlines and p being the number of spare I/Os of the memory array with the BISR.

4. Fault storage table circuit device for storage of faults for Built-In Self-Repair (BISR) of embedded-RAMs, wherein

   - said fault storage table is composed of N lines (N is an integer), each one including a wordline address register (WL(i)), and
   - said fault storage table is configured to store faults in the same cycle in which they are detected,

**characterized in that** the fault storage table further includes a faulty bitmap register (BMP(i)) and an enable flag register (EN(i)) wherein, when an error is detected, if a current faulty wordline address (cWL) is equal to the wordline address already stored in the wordline address register (WL(i)) and a corresponding enable flag of the enable flag register (EN(i)) is set, the fault storage table is configured to activate an update signal (update(i)) for the i-th line of the fault storage table and to store a full failure bitmap of the failing i-th line by updating by a bit-by-bit OR-operation between a current failure bitmap value (cBMP) and an old one stored in the faulty bitmap register (BMP(i)).

5. Device according to claim 4,
   **characterized by** a common table control logic block for the fault storage table.

6. Device according to claim 5,
   **characterized in that** the common table control logic block is configured to

   - use a common counter (cur_pos) to point to the first available (blank) line of the fault storage table, and,
   - in case that the wordline address is not already stored in the fault storage table, activate a load signal (load (i)) which commands the cur_pos-th line to store the current wordline address and faulty bitmap coming from a BIST (Built-In Self-Test), also setting the corresponding enable flag in the enable register (EN(i)), wherein at the same time an incrementing signal (inc_pos) is activated, which incrementing signal (inc_pos) increments the common counter (cur_pos) in the following cycle.

7. Device according to any of claims 4 to 6,
   **characterized in that** the number N of lines of the fault storage table is determined in such a way that, if all the lines have been used, there is at least one forced choice for a spare wordline or a spare bitline or the memory array with the BISR declared unrepairable with the given number of spare wordlines or bitlines.

8. Device according to any of claims 4 to 7,
   **characterized in that** the number N of lines of the fault storage table is equal to or greater than a number $N_{min}$, wherein said number $N_{min}$ is calculated as $N_{min} = m \cdot (p+1) + 1 = m \cdot p + m + 1$ with m being the number of spare-wordlines and p being the number of spare I/Os of the memory array with the BISR.

9. Device according to claim 6,
   **characterized in that** said fault storage table is configured to store a full failure bitmap for each failing word.

10. Device according to claim 6 or 9,
    **characterized in that** it is arranged such that

    - the common counter (cur_pos) value varies between 0 and the number of lines in the fault storage table N and
    - the load signal (load(i)) and the incrementing signal (inc_pos) are activated only if the common counter (cur_pos) value is less than N.

11. Device according to claim 9 or 10,
    **characterized in that** the number N of lines of the fault storage table is determined in such a way that, if all the lines have been used, there is at least one forced choice for a spare wordline or a spare bitline or the memory array with the BISR declared unrepairable with the given number of spare wordlines or bitlines.

12. Device according to any of claims 9 to 11,
    **characterized in that** the number N of lines of the fault storage table is equal to or greater than a number $N_{min}$, wherein said number $N_{min}$ is calculated as $N_{min} = m \cdot (p+1) + 1 = m \cdot p + m + 1$ with m being the number of spare wordlines and p being the number of spare I/Os of the memory array with the BISR.

**Patentansprüche**

1. Verfahren zur Speicherung von Fehlern für eingebaute Selbstreparatur (BISR) von eingebetteten RAMs, wobei eine Fehlerspeichertabelle verwendet wird, die aus N Leitungen zusammengesetzt ist (N ist eine ganze Zahl), die jeweils ein Wortleitungsadressenregister (WL(i)) enthalten, und wobei die Fehler in demselben Zyklus gespeichert werden, in dem sie detektiert werden,
   **dadurch gekennzeichnet, dass**, wenn ein Fehler detektiert wird, wenn eine aktuelle fehlerhafte Wortleitungsadresse (cWL) gleich der bereits in dem Wortleitungsadressenregister (WL(i)) gespeicherten Wortleitungsadresse ist und ein entsprechendes Freigabeflag gesetzt ist, ein Aktualisierungssignal (update (i)) für die i-te Leitung der Fehlerspeichertabelle aktiviert wird und dann eine Vollausfallbitmap der ausfallenden i-ten Leitung durch Aktualisieren durch eine bitweise OR-Operation zwischen einem aktuellen Ausfallbitmapwert (cBMP) und einem in einer Fehlerhaft-Bitmap-Register (BMP(i)) gespeicherten alten gespeichert wird.

**2.** Verfahren nach Anspruch 1,
**dadurch gekennzeichnet, dass** die Anzahl N der Leitungen der Fehlerspeichertabelle dergestalt bestimmt wird, dass, wenn alle Leitungen benutzt worden sind, mindestens eine erzwungene Auswahl für eine Ersatzwortleitung oder eine Ersatzbitleitung besteht, oder die Speichermatrix mit der BISR als mit der gegebenen Anzahl von Ersatzwortleitungen oder -bitleitungen unreparierbar erklärt wird.

**3.** Verfahren nach einem der vorhergehenden Ansprüche, **dadurch gekennzeichnet, dass** die Anzahl N der Leitungen der Fehlerspeichertabelle größer oder gleich einer Zahl $N_{min}$ ist, wobei die Zahl $N_{min}$ als $N_{min} = m \cdot (p+1) + 1 = m \cdot p + m + 1$ berechnet wird, wobei m die Anzahl der Ersatzwortleitungen und p die Anzahl der Ersatz-I/Os der Speichermatrix mit der BISR ist.

**4.** Fehlerspeichertabellen-Schaltungseinrichtung zum Speichern von Fehlern zur eingebauten Selbstreparatur (BISR) von eingebetteten RAMs, wobei

   - die Fehlerspeichertabelle aus N Leitungen (N ist eine ganze Zahl) zusammengesetzt ist, die jeweils ein Wortleitungsadressenregister (WL (i)) enthalten, und
   - die Fehlerspeichertabelle dafür ausgelegt ist, Fehler in demselben Zyklus zu speichern, in dem sie detektiert werden,

**dadurch gekennzeichnet, dass** die Fehlerspeichertabelle ferner ein Fehlerhaft-Bi:tmap-Register (BMP (i)) und ein Freigabeflagregister (EN (i)) enthält, wobei, wenn ein Fehler detektiert wird, wenn eine aktuelle fehlerhafte Wortleitungsadresse (cWL) gleich der bereits in dem Wortleitungsadressenregister (WL(i)) gespeicherten Wortleitungsadresse ist und ein entsprechendes Freigabeflag des Freigabeflagregisters (EN(i)) gesetzt ist, die Fehlerspeichertabelle dafür ausgelegt ist, ein Aktualisierungssignal (update(i)) für die i-te Leitung der Fehlerspeichertabelle zu aktivieren und eine Vollausfallbitmap der ausfallenden i-ten Leitung durch Aktualisieren durch eine bitweise OR-Operation zwischen einem aktuellen Ausfallbitmapwert (cBMP) und einem in dem Fehlerhaft-Bitmap-Register (BMP (i) gespeicherten alten zu speichern.

**5.** Einrichtung nach Anspruch 4,
**gekennzeichnet durch** einen gemeinsamen Tabellensteuerlogikblock für die Fehlerspeichertabelle.

**6.** Einrichtung nach Anspruch 5,
**dadurch gekennzeichnet, dass** der gemeinsame Tabellensteuerlogikblock für Folgendes ausgelegt ist:

   - Verwenden eines gemeinsamen Zählers (cur_pos) zum Zeigen auf die erste verfügbare (leere) Leitung der Fehlerspeichertabelle und
   - falls die Wortleitungsadresse nicht bereits in der Fehlerspeichertabelle gespeichert ist, Aktivieren eines Ladesignals (load(i)), das der cur_pos-ten Leitung befiehlt, die aktuelle Wortleitungsadresse und die aus einer BIST (eingebauten Selbstprüfung) kommende fehlerhafte Bitmap zu speichern, wobei auch das entsprechende Freigabeflag in dem Freigaberegister (EN(i)) gesetzt wird, wobei gleichzeitig ein Inkrementierungssignal (inc_pos) aktiviert wird, wobei das Inkrementierungssignal (inc_pos) den gemeinsamen Zähler (cur_pos) in dem folgenden Zyklus inkrementiert.

**7.** Einrichtung nach einem der Ansprüche 4 bis 6,
**dadurch gekennzeichnet, dass** die Anzahl N der Leitungen der Fehlerspeichertabelle dergestalt bestimmt wird, dass, wenn alle Leitungen benutzt worden sind, mindestens eine erzwungene Auswahl für eine Ersatzwortleitung oder eine Ersatzbitleitung besteht, oder die Speichermatrix mit der BISR als mit der gegebenen Anzahl von Ersatzwortleitungen oder -bitleitungen unreparierbar erklärt wird.

**8.** Einrichtung nach einem der Ansprüche 4 bis 7,
**dadurch gekennzeichnet, dass** die Anzahl N der Leitungen der Fehlerspeichertabelle größer oder gleich einer Zahl $N_{min}$ ist, wobei die Zahl $N_{min}$ als $N_{min} = m \cdot (p+1) + 1 = m \cdot p + m + 1$ berechnet wird, wobei m die Anzahl der Ersatzwortleitungen und p die Anzahl der Ersatz-I/Os der Speichermatrix mit der BISR ist.

**9.** Einrichtung nach Anspruch 6,
**dadurch gekennzeichnet, dass** die Fehlerspeichertabelle dafür ausgelegt ist, eine Vollausfallbitmap für jedes ausfallende Wort zu speichern.

**10.** Einrichtung nach Anspruch 6 oder 9,
**dadurch gekennzeichnet, dass** sie so angeordnet ist, dass

- der Wert des gemeinsamen Zählers (cur_pos) zwischen 0 und der Anzahl der Leitungen in der Fehlerspeichertabelle N variiert und
- das Ladesignal (load(i)) und das Inkremeitierungssignal (inc_pos) nur aktiviert werden, wenn der Wert des gemeinsamen Zählers (cur_pos) kleiner als N ist.

**11.** Einrichtung nach Anspruch 9 oder 10,
**dadurch gekennzeichnet, dass** die Anzahl N der Leitungen der Fehlerspeichertabelle dergestalt bestimmt wird, dass, wenn alle Leitungen benutzt worden sind, mindestens eine erzwungene Auswahl für eine Ersatzwortleitung oder eine Ersatzbitleitung besteht, oder die Speichermatrix mit der BISR als mit der gegebenen Anzahl von Ersatzwortleitungen oder -bitleitungen unreparierbar erklärt wird.

**12.** Einrichtung nach einem der Ansprüche 9 bis 11,
**dadurch gekennzeichnet, dass** die Anzahl N der Leitungen der Fehlerspeichertabelle größer oder gleich einer Zahl $N_{min}$ ist, wobei die Zahl $N_{min}$ als $N_{min} = m \cdot (p+1)+1 = m \cdot p+m+1$ berechnet wird, wobei m die Anzahl der Ersatzwortleitungen und p die Anzahl der Ersatz-I/Os der Speichermatrix mit der BISR ist.

## Revendications

**1.** Procédé de mémorisation d'erreurs pour l'autoréparation (BISR) de RAM emboîtées, dans lequel on utilise une table de mémorisation d'erreurs composée de N lignes (N est un nombre entier), chacune comprenant un registre (WI(i)) d'adresse de ligne de mot, et dans lequel on mémorise les erreurs dans le cycle même dans lequel elles sont détectées,
**caractérisé en ce que**, lorsqu'une erreur est détectée, si une adresse (cWL) présente de ligne de mot fautive est égale à l'adresse de ligne de mot déjà mémorisée dans le registre (WL(i)) d'adresse de ligne de mot et si un drapeau correspondant de validation est mis, on active un signal (update (i) ) de mise à jour de la i$^{\text{ème}}$ ligne de la table de mémorisation d'erreurs, puis on mémorise une représentation complète en mode point des défaillances de la i$^{\text{ème}}$ ligne défaillante en mettant à jour une opération OU bit à bit entre une valeur (cBMP) présente de représentation en mode point de défaillances et une valeur ancienne mémorisée dans un registre (BMP(i)) défaillant de représentation en mode point.

**2.** Procédé suivant la revendication 1,
**caractérisé en ce qu'**on détermine le nombre N de lignes de la table de mémorisation d'erreurs, de manière à ce que, si toutes les lignes ont été utilisées, il y ait au moins un choix forcé pour une ligne de mot en blanc ou une ligne de bit en blanc ou la matrice de mémoire ayant le BISR déclaré irréparable avec le nombre donné de lignes de mot ou de lignes de bit en blanc.

**3.** Procédé suivant l'une quelconque des revendications précédentes,
**caractérisé en ce que** le nombre N de lignes de la table de mémorisation d'erreurs est supérieur ou égal à un nombre $N_{min}$, le nombre $N_{min}$ étant calculé par $N_{min} = m \cdot (p+1) +1 = m \cdot p+m+1$, m étant le nombre de lignes de mot en blanc et p étant le nombre de I/Os en blanc de la matrice de mémoire ayant le BISR.

**4.** Dispositif de circuit à table de mémorisation d'erreurs pour mémoriser des erreurs pour une autoréparation de RAM emboîtées, dans lequel

- la table de mémorisation d'erreurs est composée de N lignes (N est un nombre entier), chacune comprenant un registre (WL(i)) d'adresse de ligne de mot, et
- la table de mémorisation d'erreurs est configurée pour mémoriser des erreurs dans le cycle même dans lequel elles sont détectées,

**caractérisé en ce que** la table de mémorisation d'erreurs comprend, en outre, un registre (BMP(i)) fautif de représentation en mode point et un registre (EN(i)) de drapeau de validation, dans lequel, lorsqu'une erreur est détectée, si une adresse (cWL) présente de ligne de mot défectueuse est égale à l'adresse de ligne de mot déjà mémorisée dans le registre (WL(i)) d'adresse de ligne de mot et si un drapeau de validation correspondant du registre (EN(i)) de drapeau de validation est mis, la table de mémorisation d'erreurs est configurée pour activer un signal (update (i)) de mise à jour pour la $i^{\text{ième}}$ ligne de la table de mémorisation d'erreurs et pour mémoriser une représentation complète défectueuse en mode point de la $i^{\text{ième}}$ ligne défectueuse en mettant à jour par une opération OU bit à bit entre une valeur (cBMP) de représentation en mode point défectueuse et une valeur ancienne mémorisée dans le registre (BMP(i)) défectueux de représentation en mode point.

5.  Dispositif suivant la revendication 4,
    **caractérisé par** un bloc logique commun de commande de la table de mémorisation d'erreurs.

6.  Dispositif suivant la revendication 5,
    **caractérisé en ce que** le bloc logique commun de commande de la table est configuré pour

    - utiliser un compteur (cur_pos) commun pour pointer vers la première ligne disponible (vide) de la table de mémorisation d'erreurs, et
    - dans le cas où l'adresse de ligne de mot n'est pas déjà mémorisée dans la table de mémorisation d'erreurs, activer un signal (load(i)) de charge qui ordonne à la cur_pos$^{\text{ième}}$ ligne de mémoriser l'adresse présente de ligne de mot et la représentation défectueuse en mode point provenant d'un BIST (test d'autoréparation) en mettant également le drapeau correspondant de validation dans le registre (EN(i)) de validation, dans lequel en même temps un signal (inc_pos) d'incrémentation est activé, ce signal (inc_pos) d'incrémentation incrémentant le compteur (cur_pos) commun dans le cycle suivant.

7.  Dispositif suivant l'une quelconque des revendications 4 à 6,
    **caractérisé en ce que** le nombre N de lignes de la table de mémorisation d'erreurs est déterminé de manière à ce que, si toutes les lignes ont été utilisées, il y ait au moins un choix forcé pour une ligne de mot en blanc ou une ligne de bit en blanc ou la matrice de mémoire ayant le BISR déclaré irréparable avec le nombre donné de lignes de mot ou de lignes de bit en blanc.

8.  Dispositif suivant l'une quelconque des revendications 4 à 7.
    **caractérisé en ce que** le nombre N de lignes de la table de mémorisation d'erreurs est supérieur ou égal à un nombre $N_{min}$, le nombre $N_{min}$ étant calculé par $N_{min} = m \cdot (p+1)+1 = m \cdot p+m+1$, m étant le nombre de lignes de mot en blanc et p étant le nombre de I/Os en blanc de la matrice de mémoire ayant le BISR.

9.  Dispositif suivant la revendication 6,
    **caractérisé en ce que** la table de mémorisation d'erreurs est configurée pour mémoriser une représentation en mode point complète de défaillances pour chaque mot défaillant.

10. Dispositif suivant la revendication 6 ou 9,
    **caractérisé en ce qu'**il est agencé de manière à ce que

    - la valeur du compteur (cur_pos) commun varie entre 0 et le nombre N de lignes dans la table de mémorisation d'erreurs et
    - le signal (load(i)) de charge et le signal (inc_pos) d'incrémentation sont activés seulement si la valeur du compteur (cur_pos) commun est inférieur à N.

11. Dispositif suivant la revendication 9 ou 10,
    **caractérisé en ce que** le nombre N de lignes de la table de mémorisation d'erreurs est déterminé de façon à ce que, si toutes les lignes ont été utilisées, il y ait au moins un choix forcé pour une ligne de mot en blanc ou une ligne de bit en blanc ou la matrice de mémoire ayant le BISR déclaré irréparable avec le nombre donné de lignes de mot ou de lignes de bit en blanc.

12. Dispositif suivant l'une quelconque des revendications 9 à 11,
    **caractérisé en ce que** le nombre N de lignes de la table de mémorisation d'erreurs est supérieur ou égal à un nombre $N_{min}$, le nombre $N_{min}$ étant calculé par $N_{min} = m \cdot (p+1) +1 = m \cdot p+m+1$, m étant le nombre de lignes de mot en blanc et p étant le nombre de I/Os en blanc de la matrice de mémoire ayant le BISR.

| Faulty Wordline Address | I/O Failure Bitmap | "Enable" Flag |
|---|---|---|
| WL(0) [a-1:0] | BMP(0) [d-1:0] | EN(0) |
| WL(1) [a-1:0] | BMP(1) [d-1:0] | EN(1) |
| | | |
| WL(N-1) [a-1:0] | BMP(N-1) [d-1:0] | EN(N-1) |

Common Table Control Logic

Fig. 1

EP 1 480 228 B1

Fig. 2

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **Borri, S.** A recursive 'at-speed' Built-In Self-Repair (BISR) method for the allocation of redundant rows and columns in an embedded-RAM. *Siemens Technology Report,* December 2002, 37-41
- **Bhavsar, D. K.** An Algorithm for Row-Column Self-Repair of RAMs and Its Implementation in the Alpha 21264. *Proc. of the International Test Conference (ITC),* 1999, 311-318
- **Kim, H.-C. et al.** A BISR (Built-In Self-Repair) circuit for embedded memory with multiple redundancies. *Proc. of IEEE 6th International Conference on VLSI and CAD (ICVC),* 1999, 602-605

- **Kawagoe, T. et al.** A Built-In Self-Repair Analyzer (CRESTA) for embedded DRAMs. *Proc. of the International Test Conference (ITC),* 2000, 567-574
- **Nakahara, S. et al.** Built-In Self-Test for GHz Embedded SRAMs Using Flexible Pattern Generator and new Repair Algorithm. *Proc. of the International Test Conference (ITC),* 1999, 301-310
- **Nagura, Y.** Test cost reduction by at-speed BISR for embedded DRAMs. *Proc. of the International Test Conference (ITC),* 2001, 182-187